# EUROPÄISCHE PATENTSCHRIFT

(11) **EP 1 726 819 B1**
(45) Veröffentlichungstag und Bekanntmachung des Hinweises auf die Patenterteilung: **11.05.2016**
(21) Anmeldenummer: 06112069.7
(22) Anmeldetag: 31.03.2006
(51) Int. Cl.: F02M 51/06, F02M 51/00, F02M 61/16, F02M 61/12

(54) **Kraftstoff-Einspritzvorrichtung, insbesondere für eine Brennkraftmaschine mit Kraftstoff-Direkteinspritzung**
Fuel injection device, in particular for an internal combustion engine with direct fuel injection
Dispositif d'injection de carburant, en particulier pour un moteur de combustion interne avec injection directe de carburant

(30) Priorität: 25.05.2005 DE 102005024049
(43) Veröffentlichungstag der Anmeldung: 29.11.2006
(73) Patentinhaber: ROBERT BOSCH GMBH, 70442 Stuttgart (DE)
(72) Erfinder: Hofmann, Dominikus, 87629, Fuessen (DE)

(56) Entgegenhaltungen:
- EP-A1- 1 593 837
- EP-A2- 1 096 136
- WO-A-03/018996
- DE-A1- 10 310 788
- DE-A1- 19 650 900
- DE-A1- 19 727 992

## Beschreibung

### Stand der Technik

Die Erfindung betrifft eine Kraftstoff-Einspritzvorrichtung, insbesondere für eine Brennkraftmaschine mit Kraftstoff-Direkteinspritzung nach dem Oberbegriff des Anspruchs 1.

Eine solche Kraftstoff-Einspritzvorrichtung ist vom Markt her bekannt. Sie wir an eine Kraftstoff-Sammelleitung ("Rail") angeschlossen, in der der Kraftstoff unter hohem Druck gespeichert ist. Die Kraftstoff-Einspritzvorrichtung spritzt den Kraftstoff direkt in einen ihr zugeordneten Brennraum der Brennkraftmaschine ein. Als Kraftstoff kommt Diesel ebenso wie Benzin in Frage.

Die bekannte Kraftstoff-Einspritzvorrichtung umfasst ein Ventilelement, welches mittelbar oder unmittelbar durch einen Piezoaktor betätigt wird. Bei der mittelbaren Betätigung ist zwischen Piezoaktor und Ventilelement ein hydraulischer Koppler geschaltet, durch den eine hydraulische Übersetzung, im Allgemeinen eine Hubverstärkung, bewirkt wird. Auf diese Weise können mit einem Piezoaktor mit vergleichsweise geringem Hub am eigentlichen Ventilelement auch große Hübe realisiert werden. Bei der unmittelbaren Betätigung sind die Hübe identisch. Bekannt ist ferner die Verwendung eines Piezoaktors zum Schalten eines hydraulischen Schaltventils, welches wiederum die Stellung des Ventilelements der Kraftstoff-Einspritzvorrichtung beeinflusst.

Um Querkräfte vom Piezoaktor im Betrieb der Kraftstoff-Einspritzvorrichtung fernzuhalten, ist die entsprechende gehäuseseitige Befestigung des Piezoaktors in Form eines Kugelgelenklagers realisiert. Ein solches muss vergleichsweise genau gefertigt sein, unter anderem auch, um eine sichere Abdichtung des im Bereich des Piezoaktors herrschenden hohen Kraftstoffdrucks zu gewährleisten.

DE 197 27 992 A1 beschreibt ein ölgefülltes Ausgleichselement zur Kompensation temperaturbedingter Längenänderungen beispielsweise eines Piezoaktors.

In der EP 1 593 837 A wird die lagerung des Piezoaktors durch ein elastisches Dichtelement gebildet, das ein Kopplervolumen umschließt. Das Dichtelement ist dabei ähnlich zu einem Wellbalg aufgebaut und erlaubt einen Winkelversatz.

Aufgabe der vorliegenden Erfindung ist es, eine Kraftstoff-Einspritzvorrichtung der eingangs genannten Art so weiterzubilden, dass sie preiswert hergestellt werden kann, der Piezoaktor eine lange Lebensdauer aufweist, und eine sichere Abdichtung gegen Kraftstoffleckagen vorliegt.

Diese Aufgabe wird durch eine Kraftstoff-Einspritzvorrichtung mit den Merkmalen des Anspruchs 1 gelöst. Vorteilhafte Ausgestaltungen sind in Unteransprüchen angegeben.

### Vorteile der Erfindung

Bei der erfindungsgemäßen Kraftstoff-Einspritzvorrichtung kann auf die Kugelgelenklagerung des Piezoaktors gegenüber dem Gehäuse verzichtet werden. Damit entfällt zum einen die Fertigungs- und zum anderen die Abdichtungsproblematik. Das erfindungsgemäß vorgesehene Festkörpergelenk kann demgegenüber sehr preiswert hergestellt werden und ist einstückig und daher absolut fluiddicht. Selbst bei niedrigen Drücken, bei denen der Piezoaktor nur mit vergleichsweise geringer Kraft gegen das Festkörpergelenk gedrückt wird, bleibt die gute Abdichtung erhalten. Die erfindungsgemäße Kraftstoff-Einspritzvorrichtung ist darüber hinaus auch einfacher und schneller fertigbar, da insgesamt weniger Teile montiert werden müssen. Schließlich kann ein solches Festkörpergelenk sehr klein bauen und auch komplexe Geometrien aufweisen, die das Einsatzspektrum nochmals erhöhen.

Grundlage für die erfindungsgemäße Kraftstoff-Einspritzvorrichtung ist die Erkenntnis, dass der auszugleichende Winkelfehler beim Piezoaktor vergleichsweise klein ist und typischerweise im Bereich vom 0,15 bis 0,17 Grad liegt, was einer Auslenkung des vom Lager abgewandten Kopfes des Piezoaktors von ungefähr 0,2 mm entspricht. Mit einem typischen Festkörperlager kann ein solcher Winkelfehler ausgeglichen werden, ohne dass die auf den Piezoaktor wirkende Querkraft 1 Newton übersteigt. Bei einer Ausgestaltung des Festkörpergelenks mit zwei zueinander in etwa orthogonalen Gelenkstegen wird dieses Verhalten bereits bei relativ breiten Stegen von typischerweise 0,5 mm Breite erreicht. Selbst bei hohen Fluiddrücken bleibt in diesem Fall die Stabilität des Festkörpergelenks erhalten.

Durch die Einstückigkeit des Festkörpergelenks wird auch die Durchführung eines elektrischen Anschlusskabels erleichtert, indem ein durchgehender Kanal vergleichsweise einfach eingebracht werden kann. Dies gilt ebenso für eine Verschlussmasse, mit der dieser Kanal fluiddicht vergossen wird. Aufgrund der hohen Stabilität des Festkörpergelenks kann dieses im Gehäuse auch verklemmt, verpresst oder verschweißt, oder auf eine andere Art und Weise mit hoher Kraft festgelegt werden. Auch ein Verkleben des Piezoaktors mit dem Festkörpergelenk ist aufgrund der Stabilität des Lagers einfacher.

### Zeichnungen

Nachfolgend wird ein besonders bevorzugtes Ausführungsbeispiel der vorliegenden Erfindung unter Bezugnahme auf die beiliegende Zeichnung näher erläutert. In der Zeichnung zeigen:
- Figur 1: eine schematische Darstellung einer Brennkraftmaschine mit einer Kraftstoff-Einspritzvorrichtung;
- Figur 2: einen teilweisen Schnitt durch einen Bereich der Kraftstoff-Einspritzvorrichtung von Figur 1;
- Figur 3: eine perspektivische Darstellung eines Festkörpergelenks der Kraftstoff-Einspritzvorrichtung von Figur 1; und
- Figur 4: eine schematische Darstellung zur Erläuterung der Funktion des Festkörpergelenks von Figur 3.

### Beschreibung der Ausführungsbeispiele

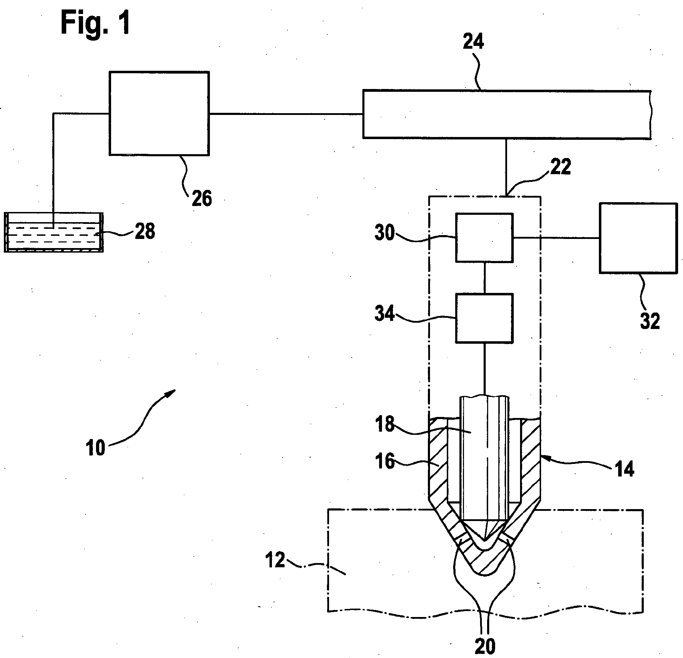

Eine Brennkraftmaschine trägt in Figur 1 insgesamt das Bezugszeichen 10. Sie umfasst unter anderem einen Brennraum 12, in den der Kraftstoff direkt von einer Kraftstoff-Einspritzvorrichtung 14 eingespritzt wird.

Die Kraftstoff-Einspritzvorrichtung 14 umfasst ein Gehäuse 16, in dem ein nadelartiges und in seiner Längsrichtung bewegliches Ventilelement 18 aufgenommen ist. Durch das Ventilelement 18 können Kraftstoff-Austrittskanäle 20 mit einem Hochdruckanschluss 22 verbunden oder von diesem getrennt werden. Über den Hochdruckanschluss 22 ist die Kraftstoff-Einspritzvorrichtung 14 an eine Kraftstoff-Sammelleitung 24 ("Rail") angeschlossen, in der der Kraftstoff, beispielsweise Diesel, unter sehr hohem Druck gespeichert ist. Hierzu wird der Kraftstoff von einer Fördereinrichtung 26 aus einem Kraftstoff-Vorratsbehälter 28 in die Kraftstoff-Sammelleitung 24 gefördert.

Zur Betätigung des Ventilelements 18 dient bei der Kraftstoff-Einspritzvorrichtung 14 ein Piezoaktor 30, der von einer Steuer- und Regeleinrichtung 32 unter Zwischenschaltung einer nicht dargestellten Endstufe angesteuert wird. Im vorliegenden Ausführungsbeispiel ist der Piezoaktor 30 mit dem Ventilelement 18 unter Zwischenschaltung eines hydraulischen Kopplers 34 gekoppelt. Hierdurch wird eine Übersetzung des Hubs des Piezoaktors 30 erreicht.

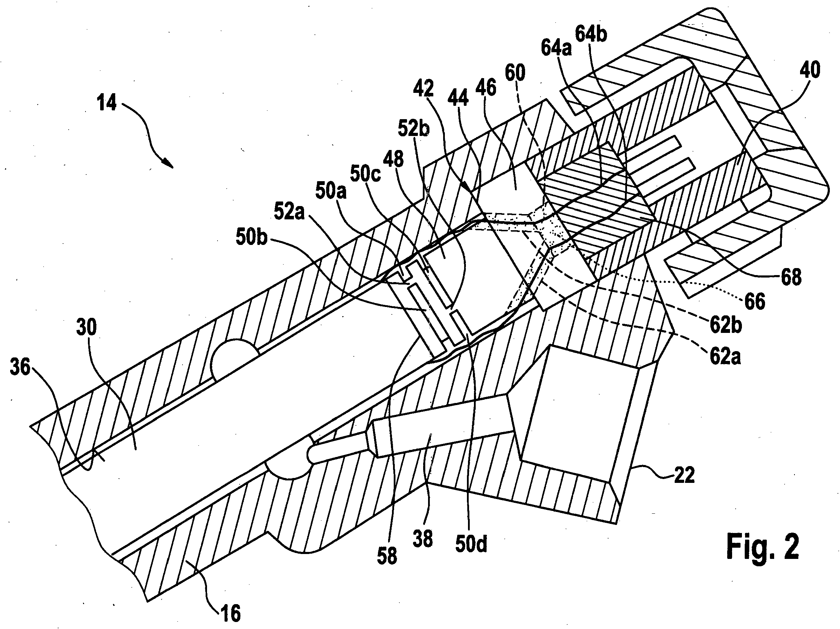

Wie aus Figur 2 hervorgeht, handelt es sich bei dem Piezoaktor 30 um ein langgestrecktes zylindrisches Teil. Er ist in einer länglichen Ausnehmung 36 im Gehäuse 16 aufgenommen, die über einen Kanal 38 mit dem Hochdruckanschluss 22 verbunden ist. Nach außen hin ist die Ausnehmung 36 durch ein Verschlusselement 40 verschlossen. Durch dieses wird ein Festkörpergelenk 42 gegen einen gehäuseseitigen.Absatz 44 gedrückt. Hierzu verfügt das Festkörpergelenk 42 über einen Klemmabschnitt 46, der einen größeren Durchmesser aufweist als ein Gelenkabschnitt 48 des Festkörpergelenks 42. Der Gelenkabschnitt 48 ist bei dem vorliegenden Ausführungsbeispiel insgesamt zylindrisch und hat in etwa den gleichen Durchmesser wie der Piezoaktor 30. Grundsätzlich ist aber auch eine ganz andere Querschnittsgeometrie, beispielsweise quadratisch, denkbar. Gelenkabschnitt 48 und Klemmabschnitt 46 des Festkörpergelenks 42 sind insgesamt einstückig.

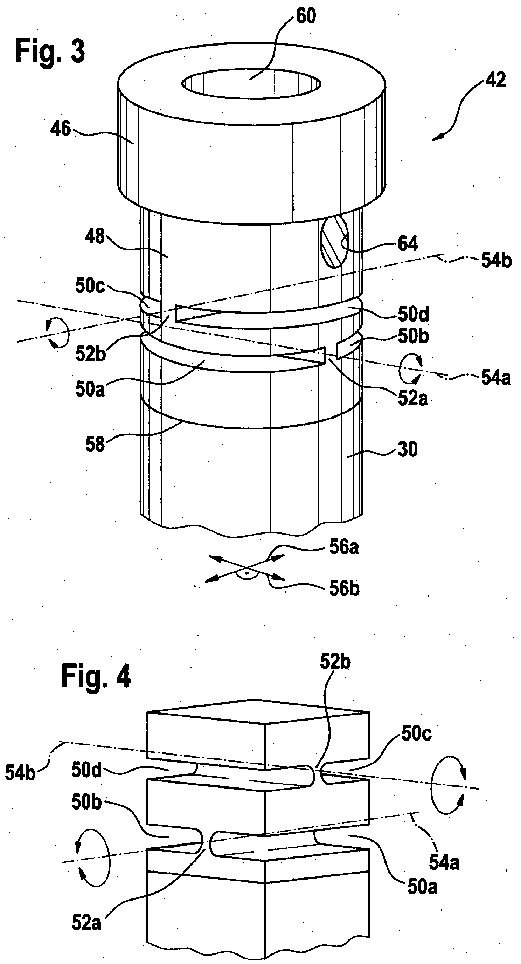

Wie auch aus Figur 3 hervorgeht, wird das Festkörpergelenk 42 durch schlitzförmige Ausnehmungen 50a und 50b in einer ersten Zylinderebene und schlitzförmige Ausnehmungen 50c und 50d in einer zweiten Zylinderebene gebildet. Die Ausnehmungen 50 sind so in den Gelenkabschnitt 48 von der Seite her eingebracht, dass in der Mitte jeweils ein Gelenksteg 52a und 52b stehen bleibt. In einem typischen Ausführungsbeispiel sind die Gelenkstege 52a und 52b ungefähr 0,5 mm dick.

Wie auch aus der schematisierten Funktionsdarstellung von Figur 4 hervorgeht, sind die Längsachsen 54a und 54b der beiden Gelenkstege 52a und 52b in Längsrichtung des Festkörpergelenks 42 bzw. des Piezoaktors 30 gesehen zueinander orthogonal, also rechtwinklig. Durch die Ausnehmungen 50a bis 50d wird die Biegesteifigkeit des Gelenkabschnitts 48 um die Achsen 54a und 54b gezielt geschwächt, wodurch sich ein entsprechendes Biegelager ergibt. Dadurch, dass in den beiden Zylinderebenen jeweils ein Biegelager gebildet ist und die beiden Biegelager zueinander orthogonale Biegeachsen aufweisen, wird letztlich eine kardanische Lagerung geschaffen, die eine Auslenkung des Piezoaktors 30 in den beiden Raumrichtungen 56a und 56b (vgl. Figur 3) erlaubt.

Der Piezoaktor 30 ist in 58 mit dem Gelenkabschnitt 48 des Festkörpergelenks 42 verklebt. Hierdurch wird eine sehr starre Verbindung zwischen dem Piezoaktor 30 und dem Gelenkabschnitt 48 geschaffen. Aufgrund von Fertigungsungenauigkeiten können sich im Betrieb der Kraftstoff-Einspritzvorrichtung 14 Zwangsauslenkungen an dem vom Festkörpergelenk 42 entgegengesetzten Ende des Piezoaktors 30 ergeben. Derartige Zwangsauslenkungen können in der Größenordnung von 0,2 mm in jeder Raumrichtung 56a und 56b liegen. Durch die kardanische Lagerung des Piezoaktors 30 mittels des Festkörpergelenks 42 können derartige Auslenkungen des Piezoaktors 30 realisiert werden, ohne dass hierdurch eine unzulässige Querkraft auf den Piezoaktor 30 einwirkt. Typischerweise bleibt die Querkraft, die auf den Piezoaktor 30 einwirkt, unterhalb von 1 Newton. Hierdurch wir die Lebensdauer des Piezoaktors 30 deutlich erhöht.

In dem Festkörpergelenk 42 ist im Klemmabschnitt 46, auf der vom Piezoaktor 30 abgewandten Seite, eine zylindrische Einsenkung 60 vorhanden. Von dieser gehen zwei schräge Kanäle 62a und 62b aus, die in der Mantelfläche des Gelenkabschnitts 48, in der Nähe zum Klemmabschnitt 46, münden (Bezugszeichen 64 in Figur 3). Durch die Kanäle 62a und 62b ist jeweils ein elektrisches Anschlusskabel 64a und 64b hindurchgeführt. Die Kanäle 64a und 64b sind mit einer Glaseinschmelzung 66 fluiddicht verschlossen bzw. vergossen. Die Kabel 64a und 64b sind an ein Steckerelement 68 angeschlossen, welches zwischen dem Verschlusselement 40 und dem Festkörpergelenk 42 verklemmt ist.

## Patentansprüche

1. Kraftstoff-Einspritzvorrichtung (14), insbesondere für eine Brennkraftmaschine (10) mit Kraftstoff-Direkteinspritzung, mit einem Gehäuse (16) und einem Piezoaktor (30) zur Betätigung eines Ventilelements (18), wobei der Piezoaktor (30) an dem Gehäuse (16) gelagert ist, wobei die Lagerung ein ein Biegelager bildendes Festkörpergelenk (42) zum Ausgleich von Winkelfehlern umfasst, **dadurch gekennzeichnet, dass** das Festkörpergelenk (42) einen Gelenkabschnitt (48) umfasst, der in mindestens zwei Ebenen derart geschlitzt (50) ist, dass mindestens zwei zueinander wenigstens in etwa orthogonale Gelenkstege (52) gebildet werden.

2. Kraftstoff-Einspritzvorrichtung (14) nach Anspruch 1, **dadurch gekennzeichnet, dass** das Festkörpergelenk (42) mindestens einen Kanal (62) umfasst, durch den ein elektrisches Anschlusskabel (64) für den Piezoaktor (30) hindurchgeführt ist.

3. Kraftstoff-Einspritzvorrichtung (14) nach Anspruch 2, **dadurch gekennzeichnet, dass** der Kanal (62) durch eine Verschlussmasse (66) wenigstens bereichsweise ausgefüllt, insbesondere vergossen ist.

4. Kraftstoff-Einspritzvorrichtung (14) nach einem der vorhergehenden Ansprüche, **dadurch gekennzeichnet, dass** der Piezoaktor (30) mit dem Festkörpergelenk (42) verklebt ist (58).

5. Kraftstoff-Einspritzvorrichtung (14) nach einem der vorhergehenden Ansprüche, **dadurch gekennzeichnet, dass** das Festkörpergelenk (42) im Gehäuse (16) verklemmt, verpresst, oder verschweißt ist.

## Claims

1. Fuel injection device (14), in particular for an internal combustion engine (10) with direct fuel injection, having a housing (16) and having a piezo actuator (30) for actuating a valve element (18), wherein the piezo actuator (30) is mounted on the housing (16), wherein the mounting comprises a flexure joint (42), which forms a flexural mount, for compensation of angular errors, **characterized in that** the flexure joint (42) comprises a joint section (48) which is slotted (50) in at least two planes such that at least two joint webs (52) which are at least approximately orthogonal to one another are formed.

2. Fuel injection device (14) according to Claim 1, **characterized in that** the flexure joint (42) comprises at least one duct (62) through which an electrical connection cable (64) for the piezo actuator (30) is led.

3. Fuel injection device (14) according to Claim 2, **characterized in that** the duct (62) is filled at least in regions with a sealing compound (66), in particular by virtue of said sealing compound being poured in.

4. Fuel injection device (14) according to one of the preceding claims, **characterized in that** the piezo actuator (30) is adhesively bonded (58) to the flexure joint (42).

5. Fuel injection device (14) according to one of the preceding claims, **characterized in that** the flexure joint (42) is clamped, pressed or welded into the housing (16).

## Revendications

1. Dispositif d'injection de carburant (14), en particulier pour un moteur à combustion interne (10) à injection de carburant directe, comprenant un boîtier (16) et un actionneur piézo-électrique (30) pour l'actionnement d'un élément de soupape (18), l'actionneur piézo-électrique (30) étant supporté sur le boîtier (16), le support comprenant une articulation monolithique (42) formant un palier flexible pour la compensation des erreurs angulaires, **caractérisé en ce que** l'articulation monolithique (42) comprend une portion d'articulation (48) qui est fendue (50) dans au moins deux plans de telle sorte qu'au moins deux nervures d'articulation au moins approximativement orthogonales l'une à l'autre (52) soient formées.

2. Dispositif d'injection de carburant (14) selon la revendication 1, **caractérisé en ce que** l'articulation monolithique (42) comprend au moins un canal (62) à travers lequel est guidé un câble de raccordement électrique (64) pour l'actionneur piézo-électrique (30).

3. Dispositif d'injection de carburant (14) selon la revendication 2, **caractérisé en ce que** le canal (62) est rempli au moins en partie par une masse de scellement (66) en particulier coulée dans celui-ci.

4. Dispositif d'injection de carburant (14) selon l'une quelconque des revendications précédentes, **caractérisé en ce que** l'actionneur piézo-électrique (30) est collé (58) à l'articulation monolithique (42).

5. Dispositif d'injection de carburant (14) selon l'une quelconque des revendications précédentes, **caractérisé en ce que** l'articulation monolithique (42) est serrée, pressée ou soudée dans le boîtier (16).
